**Europäisches Patentamt**

**European Patent Office**

**Office européen des brevets**

(19)

(11) Veröffentlichungsnummer: **0 131 718**
**B1**

(12)
# EUROPÄISCHE PATENTSCHRIFT

(45) Veröffentlichungstag der Patentschrift:
**14.01.87**

(51) Int. Cl.⁴: **G 01 R 31/34, H 02 H 3/17**

(21) Anmeldenummer: **84105976.9**

(22) Anmeldetag: **25.05.84**

(54) Einrichtung zur Erfassung eines Erdschlusses in der Rotorwicklung einer elektrischen Maschine.

(30) Priorität: **22.06.83 CH 3405/83**

(43) Veröffentlichungstag der Anmeldung:
**23.01.85 Patentblatt 85/4**

(45) Bekanntmachung des Hinweises auf die Patenterteilung:
**14.01.87 Patentblatt 87/3**

(84) Benannte Vertragsstaaten:
**CH DE FR IT LI NL SE**

(56) Entgegenhaltungen:
**DE-A-2 357 273**
**DE-C-620 768**

**SIEMENS POWER ENG.,Band 2, Nr. 1, 1980, Seiten 13-17, München, DE; K. HENNINGER et al.: "Two-step rotor earth-fault protection of high sensitivity for synchronous machines"**

(73) Patentinhaber: **BBC Aktiengesellschaft Brown, Boveri & Cie., Haselstrasse, CH- 5401 Baden (CH)**

(72) Erfinder: **Maier, Franz, Dr., Dipl. Ing., Winzerstrasse 42B, CH- 5430 Wettingen (CH)**

## Beschreibung

Die Erfindung betrifft eine Einrichtung zur Erfassung eines Erdschlusses in der Rotorwicklung einer elektrischen Maschine gemäss dem Oberbegriff der Ansprüche 1, oder 2.

Eine solche Einrichtung findet Verwendung zum Schutz der Rotorwicklung und ist beispielsweise bekannt aus dem Artikel "Elektronischer Läufererdschlußschutz mit neuartigem Messprinzip" von E.F. Knütter und G. Ziegler in der Siemens-Zeitschrift 46 (1972) Heft 12, Seiten 906 bis 909.

Prinzipiell wirkt sich ein einzelner Erdschluss irgendwo im Rotorkreis, welcher neben der Rotorwicklung u.a. die Erregerquelle mit umfasst, nicht unmittelbar auf das Betriebsverhalten der Maschine aus. Eine Abschaltung der Maschine ist daher nicht in jedem Fall zwingend geboten. Hat sich der Erdschluss beispielsweise in der Erregerquelle ausgebildet, so kann die Maschine unter Umständen bis zur nächsten routinemässigen Abschaltung in Betrieb gehalten werden. Dagegen besteht der Wunsch, die Maschine bei einem Erdschluss direkt in der Rotor wicklung abzuschalten, da ein weiterer Erdschluss in der Rotorwicklung einen Teil derselben über Erde kurzschliessen und zu einer Zerstörung der Rotorwicklung führen könnte. Voraussetzung für eine solche selektive Abschaltung ist, den Erdschluss selektiv nach seiner Lage im Rotorkreis zu detektieren. Durch die bekannte Einrichtung werden Erdschlüsse grundsätzlich nicht selektiv im gesamten Rotorkreis angezeigt.

Aufgabe der Erfindung ist, einen selektiven Rotor-Erdschlußschutz zu schaffen. Zur Lösung dieser Aufgabe wird eine Einrichtung der eingangs genannten Art vorgeschlagen, welche erfindungsgemäss die im Anspruch 1 oder die im Anspruch 2 gekennzeichneten Merkmale aufweist.

Die mit der Erfindung erreichten Vorteile sind im wesentlichen darin zu sehen, dass allein ein Erdschluss in der Rotorwicklung das erste Relais zum Ansprechen bringt.

Weitere Vorteile sowie bevorzugte Ausgestaltungen und Weiterbildungen der Erfindung, wie sie auch in den Unteransprüchen gekennzeichnet sind, ergeben sich aus der nachstehenden Beschreibung von Ausführungsbeispielen, wobei auf die beigefügten Zeichnungen Bezug genommen wird.

Es zeigt:

Fig. 1 eine Ausführungsform des Lösungsweges mit nur einem Stromwandler sowie mit verschiedenen, strichliert dargestellten Weiterbildungen,

Fig. 2 eine Ausführungsform des Lösungsweges mit zwei Stromwandlern, ebenfalls mit strichliert dargestellten Weiterbildungen,

Fig. 3 eine erste elektromechanische Ausführungsform eines doppelt ausgeführten Wechselschalters in der Erdleitung,

Fig. 4 eine zweite elektronische Ausführungsform eines doppelt ausgeführten Wechselschalters ebenfalls in der Erdleitung.

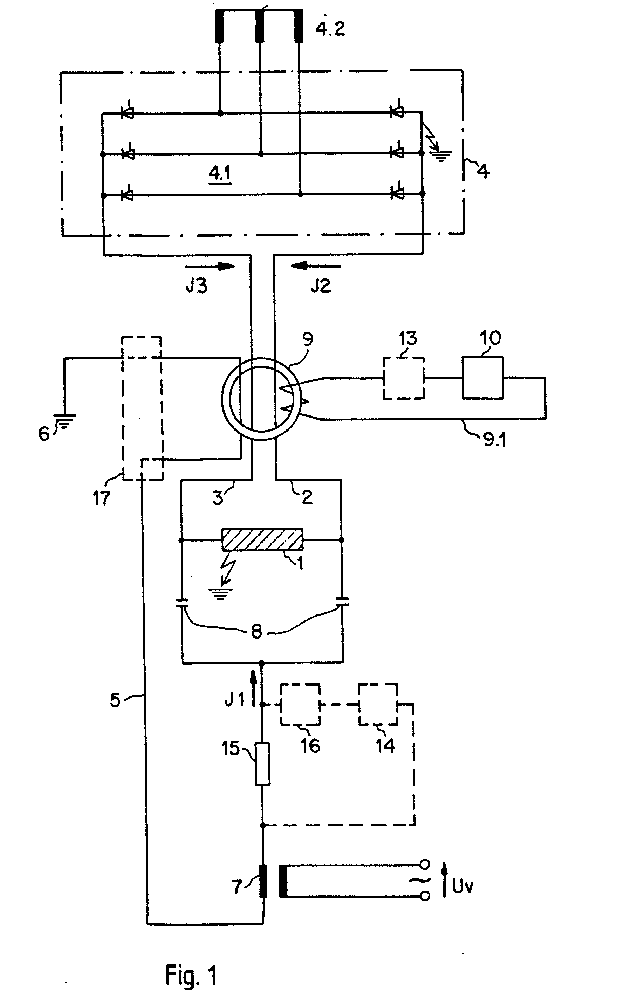

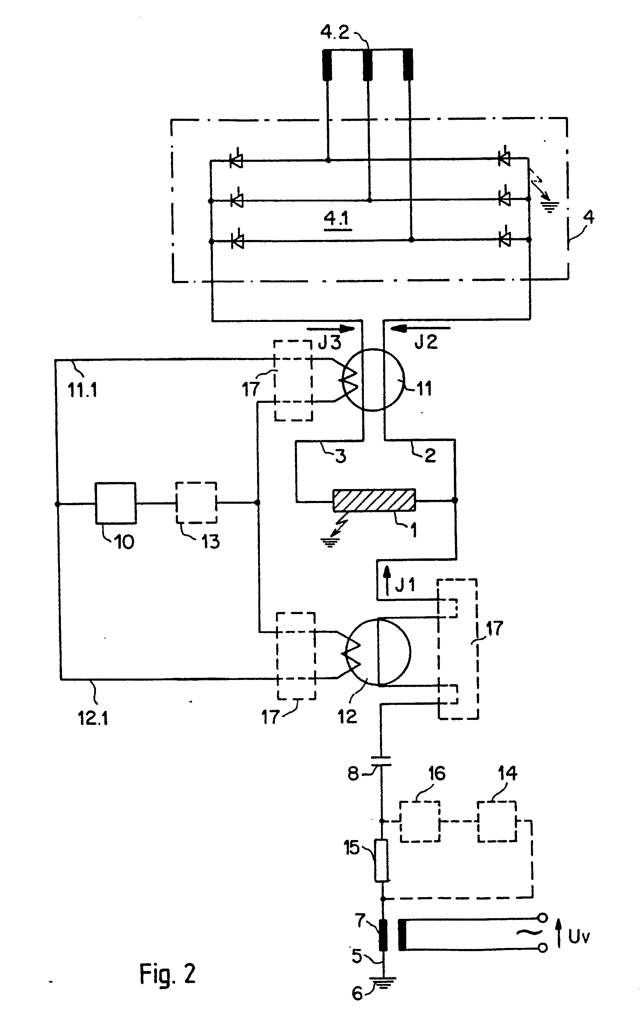

Die Fig. 1 und 2 sind Blockschaltbilder, in denen alle zum unmittelbaren Verständnis der Erfindung nicht notwendigen Schaltungsmerkmale nicht dargestellt sind. In allen Figuren sind übereinstimmende Teile mit übereinstimmenden Bezugzeichen versehen.

In Fig. 1 ist mit 1 eine Rotorwicklung bezeichnet, welche über Stromschienen 2 und 3 zwischen die Pole einer Erregerquelle 4 geschaltet ist. Die Erregerquelle 4 ist eine Gleichstromquelle und im Beispiel von Fig. 1 als Stromrichter 4.1 ausgebildet, welcher über einen Erregertransformator 4.2 an eine nicht dargestellte Wechselspannungsquelle angeschlossen ist. Von der Rotorwicklung 1 führt eine Erdleitung 5 gegen Erde 6. In der Erdleitung 5 sind in Reihe eine Wechselspannungsquelle 7 sowie ein oder mehrere Kondensatoren 8 angeordnet. Die Wechselspannungsquelle 7 wirkt in bekannter Weise als Verlagerungsspannungsquelle. Mit 9 ist ein Stromwandler bezeichnet, welcher als Schienen- bzw. Ringkernwandler ausgeführt ist. Sein ringförmiger Kern umschliesst sowohl die Erdleitung 5 als auch die Stromschienen 2 und 3 als Primärwicklungen. Alle drei Leitungen sind mit einfacher Windungszahl durch den Stromwandler 9 geführt und zwar die Erdleitung 5 von der Erde 6 zur Rotorwicklung 1 und die Stromschienen 2 und 3 von der Erregerquelle 4 ebenfalls zur Rotorwicklung 1 mit jeweils übereinstimmendem Wicklungs- bzw. Richtungssinn. Im Sekundärkreis 9.1 des Stromwandlers 9 ist ein erstes Relais 10 angeordnet.

Der Stromwandler 9 erfasst die Summe der in der Erdleitung 5 und in den Stromschienen 2 und 3 fliessenden Ströme.

In seinem Sekundärkreis 9.1 fliesst ein zu dieser Summe proportionaler Sekundärstrom. Der Strom in der Erdleitung 5 ist mit $J_1$, der Strom in der Stromschiene 2 mit $J_2$ und der Strom in der Stromschiene 3 mit $J_3$ bezeichnet. Gemäss dem Wicklungs- bzw. Richtungssinn, in dem die Erdleitung 5 sowie die Stromschienen 2 und 3, wie vorstehend beschrieben, durch den Stromwandler 9 geführt sind, werden die Ströme $J_1$, $J_2$ und $J_3$ durch den Stromwandler 9 bei der Summenbildung mit übereinstimmendem Vorzeichen in Richtung zur Rotorwicklung 1 bewertet. Entsprechende Zählpfeile sind in Fig. 1 eingezeichnet.

Im folgenden werden nacheinander ein Zustand ohne Erdschluss, ein Zustand mit einem mit 1 bezeichneten Erdschluss in der Rotorwicklung und ein Zustand mit einem mit II bezeichneten Erdschluss in der Erregerquelle 4 betrachtet.

Im erdschlussfreien Zustand ist der die Wechselspannungsquelle 7 enthaltende Stromkreis praktisch nur über die natürliche Erdkapazität der Rotorwicklung 1 geschlossen. Der über diese Erdkapazität fliessende Strom ist jedoch klein und soll im folgenden vernachlässigt werden. Damit ergibt sich der Strom $J_1$ in der Erdleitung 5 zu Null. Ueber die Rotorwicklung 1 fliesst ein durch den Stromrichter 4.1 in der Erregerquelle 4 gleichgerichteter Erregerstrom. Dieser tritt in der Stromschiene 2 als Strom $J_2$ und in der Stromschiene 3 mit gleicher Grösse, jedoch umgekehrtem Vorzeichen als Strom $J_3$ auf. Die Summe beider Ströme $J_2$ und $J_3$ ist Null. Die von den Strömen $J_2$ und $J_3$ im Stromwandler 9 verursachten Durchflutungen heben sich gegenseitig gerade auf. Dies gilt auch, wenn die Ströme $J_2$ und $J_3$ keine idealen Gleichströme, sondern mit vom Stromrichter 4.1 erzeugten Oberwellen überlagert sind. Im Sekundärkreis 9.1 des Stromwandlers 9 tritt kein Sekundärstrom auf welcher das erste Relais 10 zum Ansprechen bringen könnte. Das erste Relais 10 bleibt unerregt, und zeigt keinen Erdschluss an.

Bei einem Erdschluss in der Rotorwicklung 1 fliesst in der Erdleitung 5 ein von der Wechselspannungsquelle 7 eingeprägter Erdstrom als Strom $J_1$. Die Ströme $J_2$ und $J_3$ in den Stromschienen sind von diesem Erdstrom nicht berührt und fliessen wie im erdschlussfreien Fall, so dass sich auch die von ihnen verursachte Durchflutung im Stromwandler 9 wieder aufhebt. Es bleibt jetzt jedoch eine vom Strom $J_1$ verursachte zeitlich veränderliche Restdurchflutung im Stromwandler 9, welche einen Sekundärstrom im Sekundärkreis 9.1 zur Folge hat. Dieser Sekundärstrom bringt das erste Relais 10 zum Ansprechen, wodurch der Erdschluss angezeigt wird.

Liegt der Erdschluss in der Erregerquelle 4, so überlagert sich der in der Erdleitung 5 als Strom $J_1$ fliessende, wieder von der Wechselspannungsquelle 7 eingeprägte Erdstrom in den Stromschienen 2 und 3 dem von der Erregerquelle 4 getriebenen Erregerstrom. Der in der Erdleitung 5 den Stromwandler 9 durchsetzende Strom $J_1$, durchsetzt diesen in den Stromschienen 2 und 3 in umgekehrter Richtung noch einmal. Im Ergebnis ist die Summe der Ströme $J_1$, $J_2$, $J_3$ bzw. die von ihnen im Stromwandler 9 verursachte Durchflutung wie im erdschlussfreien Fall zu Null ausgeglichen. Im Sekundärkreis 9.1 des ersten Stromwandlers 9 fliesst kein Sekundärstrom. Das erste Relais 10 bleibt unerregt.

Durch die beschriebene Anordnung wird ein Erdschluss nur angezeigt, sofern er sich in der Rotorwicklung 1 ausgebildet hat.

Da sich die vom Anteil des Erregerstromes samt seiner Oberwellen in den Strömen $J_1$ und $J_2$ verursachten Durchflutungen im Stromwandler 9 immer gegenseitig kompensieren, ist der Stromwandler 9 in vorteilhafter Weise selbst bei hohem Erregerstrom nicht gesättigt. Auch bleiben die Oberwellen ohne Einfluss das erste Relais 10.

In Fig. 2 ist eine Ausführungsform des Lösungsweges mit zwei Stromwandlern und zwar mit einem ersten Stromwandler 11 und einem zweiten Stromwandler 12 dargestellt. Beide Stromwandler 11 und 12 sind wie der Stromwandler 9 als Schienen- bzw. Ringkernwandler mit identischem Wandlerkern und identischen Sekundärwicklungen ausgebildet. Die Stromschienen 2 und 3 sind als Primärwicklungen durch den ersten Stromwandler 11 mit übereinstimmendem Wicklungs- bzw. Richtungssinn von der Erregerquelle 4 zur Rotorwicklung sowie mit einfacher Windungszahl geführt. Durch den zweiten Stromwandler 12 ist als Primärwicklung die Erdleitung 5 ebenfalls mit einfacher Windungszahl geführt. Das erste Relais ist in den parallelgeschalteten Sekundärkreisen 11.1 und 12.1 des ersten Stromwandlers II und zweiten Stromwandlers 12 angeordnet. In allen übrigen Merkmalen entspricht die Ausführungsform nach Fig. 2 der Ausführungsform nach Fig. 1.

Im folgenden werden wiederum nacheinander ein Zustand ohne Erdschluss, ein Zustand mit einem Erdschluss in der Rotorwicklung 1 und ein Zustand mit einem Erdschluss in der Erregerquelle 4 betrachtet.

Im erdschlussfreien Zustand fliesst in der Erdleitung 5 kein Strom. Ein über die natürliche Erdkapazität der Rotorwicklung 1 fliessenden Strom sei wieder vernachlässigt. Insofern wird auch im Sekundärkreis 12.1 des zweiten Stromwandlers 12 kein Sekundärstrom erzeugt. In den Stromschienen 2 und 3 fliessen gleich grosse, aber vorzeichenmässig entgegengesetzte Ströme $J_2$ und $J_3$. Die von diesen Strömen im ersten Stromwandler 11 verursachten Durchflutungen kompensieren sich zu Null. Es wird auch im Sekundärkreis 11.1 des ersten Stromwandlers 11 kein Sekundärstrom erzeugt. Das erste Relais 10 bleibt ohne Erregung.

Bei einem Erdschluss in der Rotorwicklung 1 fliesst als Strom $J_1$ ein Erdstrom in der Erdleitung 5 und erzeugt über den zweiten Stromwandler 12 einen Sekundärstrom im Sekundärkreis 12.1. Auf den Stromschienen 2 und 3 und somit im ersten Stromwandler 11 tritt der Erdstrom nicht auf. Die Ströme $J_2$ und $J_3$ entsprechen dem erdschlussfreien Fall. Die von ihnen erzeugte Durchflutung im ersten Stromwandler 11 ist ausgeglichen. Es wird kein weiterer Sekundärstrom im Sekundärkreis 11.1 erzeugt. Der im Sekundärkreis 12.1 erzeugte Sekundärstrom bringt das erste Relais 10. zum Ansprechen, wodurch der Erdschluss angezeigt wird.

Bei einem Erdschluss in der Erregerquelle 4 fliesst als Strom $J_1$ ein Erdstrom in der Erdleitung 5, durchsetzt den zweiten Stromwandler 12, tritt dem Erregerstrom überlagert auch in den Stromschienen 2 und 3 in den Strömen $J_2$ und $J_3$ auf und durchsetzt somit auch den ersten Stromwandler 11. In den Sekundärkreisen 11.1 und 12.1 beider Stromwandler 11 und 12 werden Sekundärströme erzeugt. Sofern, wie angenommen, die Wandlerkerne und die Sekundärwicklungen der Stromwandler 11 und 12 weitgehend identisch sind, sind auch die erzeugten Sekundärströme annähernd gleich gross. Durch geeignete Wahl des Wicklungs- bzw. Richtungssinns der Erdleitung 5 im zweiten Stromwandler 12 und des Wicklungssinnes der Sekundärwicklungen des ersten 11 und zweiten Stromwandlers 12 kann dann erreicht werden, dass die Sekundärströme entgegengesetzt fliessen und sich gegenseitig kompensieren. Das erste Relais 10 spürt dann keinen resultierenden Sekundärstrom und bleibt demzufolge umerregt.

Auch bei der Ausführungsform nach Fig. 2 wird ein Erdschluss nur angezeigt, sofern er sich in der Rotorwicklung·1 ausgebildet hat.

In beiden Ausführungsformen, vorzugsweise jedoch bei der Ausführungsform gemäss Fig. 2 kann dem ersten Relais 10 ein erstes Tiefpassfilter 13 vorgeschaltet sein. Das Tiefpassfilter 13 sperrt mit Vorteil vor allem vom Stromrichter 4.1 erzeugte Oberwellen, welche das erste Relais 10 beeinträchtigen könnten.

Mit Vorteil können beide erfindungsgemässen Lösungswege in den Ausführungsformen nach Fig. 1 und Fig. 2 so weitergebildet sein, dass auch ein Erdschluss ausserhalb der Rotorwicklung 1 detektierbar ist.

Hierzu kann bei beiden Ausführungsformen ein zweites, in Fig. 1 und Fig. 2 mit 14 bezeichnetes Relais vorgesehen sein. Das zweite Relais 14 ist vorzugsweise zu einem in der Erdleitung 5 angeordneten Erdwiderstand 15 parallelgeschaltet und erfasst beispielsweise die über diesem Erdwiderstand bei einem Erdschluss abfallende Spannung. Es spricht an, sobald bei einem Erdschluss ein Strom $J_1$ in der Erdleitung 5 fliesst, unabhängig davon, wo sich dieser Erdschluss im Rotorkreis ausgebildet hat. Spricht nur das zweite Relais 14 an, das erste Relais 10 dagegen nicht, so liegt ein Erdschluss ausserhalb der Rotorwicklung 1 vor. Sprechen beide Relais gemeinsam an, so liegt ein Erdschluss in der Rotorwicklung 1 vor. Auch dem zweiten Relais 14 kann ein zweites Tiefpassfilter 16 zur Sperrung der Oberwellen vorgeschaltet sein.

Alternativ kann bei beiden Ausführungsformen auch ein Wechselschalter 17 vorgesehen sein. Der Wechselschalter 17 ist bei der Ausführungsform nach Fig. 1 in der Erdleitung 5 angeordnet. Bei der Ausführungsform nach Fig. 2 kann der Wechselschalter 17 entweder ebenfalls in der Erdleitung 5 oder aber im Sekundärkreis 11.1 des ersten Stromwandlers 11 oder im Sekundärkreis 12.1 des zweiten Stromwandlers 12 angeordnet sein. In allen diesen möglichen Anordnungen ist ein Wechselschalter 17 in den Figuren 1 und 2 strichliert eingezeichnet.

Der Wechselschalter 17 kann ein einfacher oder ein doppelter Wechselschalter sein.

Als doppelter Wechselschalter dient er dazu, abhängig von seiner gewählten Anordnung, entweder den Wicklungs- bzw. Richtungssinn der Erdleitung 5 im Stromwandler 9 bei der Ausführungsform nach Fig. 1, den Wicklungs- bzw. Richtungssinns der Erdleitung 5 im zweiten Stromwandler 12 bei der Ausführungsform nach Fig. 2, den Wicklungs- bzw. Richtungssinn der Sekundarwicklung des ersten oder des zweiten Stromwandlers 12 ebenfalls bei der Ausführungsform nach Fig. 2, umzukehren.

Die Umkehrung des Wicklungs- bzw. Richtungssinns der genannten Leitungen bzw. Sekundärwicklungen hat im erdschlussfreien Zustand keinerlei Auswirkungen, da in diesem Fall weder in der Erdleitung 5, noch in den Sekundärkreisen 11.1 oder 12.1, wie vorstehend erläutert, ein Strom fliesst.

Bei einem Erdschluss in der Rotorwicklung 1 fliesst als Strom $J_1$ lediglich ein Erdstrom in der Erdleitung 5. Die von diesem Erdstrom im Stromwandler 9 bzw. im zweiten Stromwandler 12 verursachte Durchflutung kann durch Betätigung des doppelt ausgeführten Wechselschalters 17 nicht beeinflusst werden, sofern der Wechselschalter 17 in der Erdleitung 5 oder im Sekundärkreis des zweiten Stromwandlers 12 angeordnet ist. Das Relais 10 spricht nach wie vor an.

In dem doppelt ausgeführten Wechselschalter 17 im Sekundärkreis 11.1 des ersten Stromwandlers 11 angeordnet, so hat seine Betätigung überhaupt keine Auswirkungen, da über diesen Stromwandler 11 im Sekundärkreis 11.1 kein Strom erzeugt wird. Das erste Relais 10 spricht auch bei dieser Anordnung des doppelt ausgeführten Wechselschalters unabhängig von seiner Schaltstellung an.

Liegt der Erdschluss in der Erregerquelle 4, so ergibt sich nach einer Betätigung des doppelt ausgeführten Wechselschalters 17 keine Kompensation der Durchflutungen im Stromwandler 9 bei der Ausführungsform nach Fig. 1 bzw. der Sekundärströme in den Sekundärkreisen 11.1 und 12.1 des ersten II und zweiten Stromwandlers 12 bei der Ausführungsform nach Fig. 2 mehr. Die Durchflutungen im Stromwandler 9 bzw. die Sekundärströme in den Sekundärkreisen 11.1 und 12.1 sind nunmehr gleichgerichtet und addieren sich zum doppelten Betrag. Das erste Relais 10 spricht sicher an.

Vorzugsweise wird der doppelt ausgeführte Wechselschalter 17 zunächst auf die zuletzt beschriebene Schaltstellung eingestellt, bei welcher sich keine Kompensation der Durchflutungen bzw. der Sekundärströme ergibt. Das erste Relais 10 zeigt dann Erdschlüsse im gesamten Rotorkreis unabhängig von ihrer Lage an. Nach einem Ansprechen des ersten Relais 10 kann dann der doppelt ausgeführte Wechselschalter 17 betätigt werden, um eine bezüglich der Lage des Erdschlusses selektive Anzeige zu erhalten. Bleibt das erste Relais 10 nach dem Schaltvorgang erregt, so liegt ein Erdschluss in der Rotorwicklung 1 vor. Verschwindet die Erregung, so liegt der Erdschluss ausserhalb der Rotorwicklung 1.

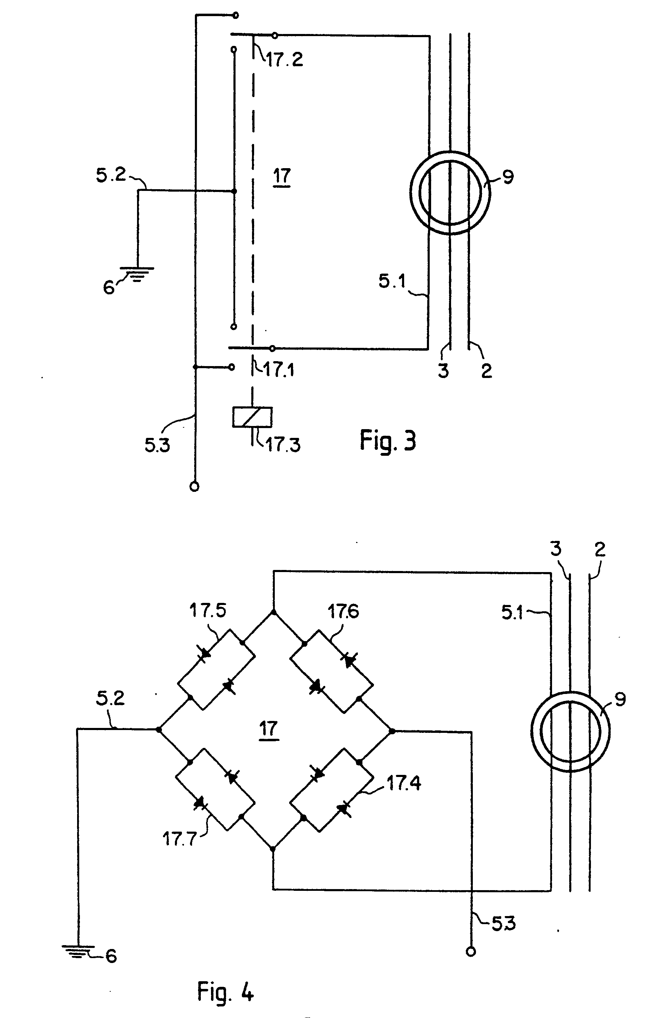

Ein erstes Ausführungsbeispiel für einen doppelt ausgeführten Wechselschalter 17, beispielsweise angeordnet in der Erdleitung 5 bei der Ausführungsform nach Fig. 1, zeigt Fig. 3. Der doppelt ausgeführte Wechselschalter 17 weist einen ersten Wechselschalter 17.1 und einen zweiten Wechselschalter 17.2 auf, welche gemeinsam von einem vorzugweise elektromechanischen Antrieb 17.3 betätigbar sind. Durch den doppelt ausgeführten Wechselschalter 17 ist die Erdleitung 5 in drei Leitungsstücke 5.1, 5.2 und 5.3 unterteilt: ein den Stromwandler 9 durchsetzendes Leitungsstück 5.1, ein erdseitiges Leitungsstück 5.2 und ein rotorwicklungsseitiges Leitungsstück 5.3. Die Wechselschalter 17.1 und 17.2 sind an den Enden des Leitungsstückes 5.1 angeordnet und verbinden diese Enden jeweils gegensinnig mit den Leitungsstücken 5.2 und 5.3.

Ein zweites Ausführungsbeispiel für einen doppelt ausgeführten Wechselschalter 17 zeigt Fig. 4. Dieser ist hier als Brückenschaltung ausgebildet, welche wiederum beispielsweise in der Erdleitung 5 bei der Ausführungsform nach Fig. 1 angeordnet ist. In jedem Teilzweig der Brückenschaltung ist als Schaltelement ein Paar antiparalleler Thyristoren 17.4, 17.5, 17.6 bzw. 17.7 angeordnet. Durch Zündung jeweils in der Brückenschaltung gegenüberliegender Thyristorpaare 17.4. und 17.5 oder 17.6 und 17.7 mittels einer nicht dargestellten Zünd- und Steuereinrichtung wird das in einem Diagonalzweig der Brückenschaltung liegende Leitungsstück 5.1 im einen oder anderen Wicklungs- bzw. Richtungssinn bezüglich des Stromwandlers 9 mit den Leitungsstücken 5.2 und 5.3 verbunden. Ein so ausgebildeter Wechselschalter ist sehr schnell. Er findet vornehmlich Verwendung, sofern innerhalb weniger Millisekunden geschaltet werden soll.

Wie vorstehend bereits erwähnt, kann der Wechselschalter 17 auch als einfacher Wechselschalter ausgeführt sein. In einfacher Ausführung dient er dazu, die Windungszahl der jeweiligen Leitung, in der er angeordnet ist, im jeweiligen Stromwandler zu verändern, zum Beispiel zu verdoppeln. Es lässt sich dann über einen Grössenvergleich der erzeugten Sekundärströme vor und nach einer Betätigung des einfach ausgeführten Wechselschalters 17 gleichfalls eine klare selektive Erfassung eines Erdschlusses erreichen.

Ist ein Erdschluss in der Rotorwicklung 1 auf einem der vorstehend beschriebenen Wege selektiv erfasst und soll die elektrische Maschine abgeschaltet werden, so müssen in der Regel eine ganze Reihe von Schaltvorgängen, wie z.B. die Unterbrechung des Rotorkreises, durchgeführt werden. Vorzugsweise erfolgt die Abschaltung automatisch und werden automatisch auch die notwendigen Schaltsignale entweder direkt vom ersten Relais 10 oder von einer separaten, in den Zeichnungen nicht dargestellten, Steuereinheit erzeugt. Durch letztere kann vor der Erzeugung der Abschaltbefehle auch der Erregungszustand des zweiten Relais 14, sofern vorhanden, mitberücksichtigt werden. Ist der Wechselschalter 17 verwendet, so kann die Steuervorrichtung zu seiner automatischen Betätigung nach einem Ansprechen des ersten Relais 10 verwendet werden sowie zu der Entscheidung, ob nach der Betätigung die Erregung des ersten Relais 10 bleibt oder verschwindet. Die Steuervorrichtung kann zur Erfüllung dieser Aufgaben in üblicher Weise aus konventionellen Schaltkreisen aufgebaut sein und braucht deshalb nicht näher beschrieben zu werden.

**Patentansprüche**

1. Einrichtung zur Erfassung eines Erdschlusses in der Rotorwicklung (1) einer elektrischen Maschine mit einem ersten Relais (10), wobei die Rotorwicklung über Stromschienen (2, 3) zwischen die Pole einer Erregerquelle (4) und über eine, einen Kondensator (8) und eine Wechselspannungsquelle (7) in Reihe enthaltende Erdleitung (5) gegen Erde (6) geschaltet ist, dadurch gekennzeichnet, dass das erste Relais (10) im Sekundärkreis (9.1) eines Stromwandlers (9) angeordnet ist, welcher primärseitig in die Stromschienen (2, 3) und in die Erdleitung (5) mit jeweils übereinstimmendem Wicklungs- bzw. Richtungssinn geschaltet ist (Fig. I).

2. Einrichtung zur Erfassung eines Erdschlusses in der Rotowicklung (1) einer elektrischen Maschine mit einem ersten Relais (10), wobei die Rotorwicklung über Stromschienen (2, 3) zwischen die Pole einer Erregerquelle (4) und über eine, einen Kondensator (8) und eine Wechselspannungsquelle (7) in Reihe enthaltende Erdleitung (5) gegen Erde (6) geschaltet ist, dadurch gekennzeichnet, dass das erste Relais (10) in die vorzugsweise parallel geschalteten Sekundärkreise (11.1, 12.1) eines ersten (II) und eines zweiten (12) Stromwandlers geschaltet ist, wobei der erste Stromwandler (11) primärseitig in die Stromschienen (2, 3) und der zweite Stromwandler (12) primärseitig in die Erdleitung (5) mit jeweils übereinstimmendem Wicklungs- bzw. Richtungssinn geschaltet ist (Fig. 2).

3. Einrichtung nach einem der Ansprüche 1 oder 2, dadurch gekennzeichnet, dass dem ersten Relais (10) Ein erstes Tiefpassfilter (13) vorgeschaltet ist.

4. Einrichtung nach einem der Ansprüche 1 bis 3, dadurch gekennzeichnet, dass der Stromwandler (9) bzw. der erste (11) und/oder der zweite Stromwandler (12) als Schienenstromwandler, insbesondere als Ringkernwandler, ausgebildet sind.

5. Einrichtung nach einem der Ansprüche 2 bis 4, dadurch gekennzeichnet, dass der erste (II) und der zweite Stromwandler (12) wenigstens annähernd identisch ausgeführte Wandlerkerne und Sekundärwicklungen aufweisen.

6. Einrichtung nach einem der Ansprüche 1 bis 5, dadurch gekennzeichnet, dass ein zweites Relais (14) vorgesehen ist, welches parallel zu einem in der Erdleitung (5) angeordneten Erdwiderstand (15) geschaltet ist.

7. Einrichtung nach Anspruch 6, dadurch gekennzeichnet, dass dem zweiten Relais (14) ein zweites Tiefpassfilter (16) vorgeschaltet ist.

8. Einrichtung nach einem der Ansprüche 1 bis 7, dadurch gekennzeichnet, dass mit einem doppelten Wechselschalter (17) der Wicklungs- bzw. Richtungssinn der Erdleitung (5) im Stromwandler (9) bzw. im zweiten Stromwandler (12) oder der Wicklungssinn der Sekundärwicklung des ersten (11) oder des zweiten Stromwandlers (12) umkehrbar ist.

9. Einrichtung nach einem der Ansprüche 1 bis 7, dadurch gekennzeichnet, dass mittels eines einfachen Wechselschalters (17) die Windungszahl der Erdleitung (5) im Stromwandler (9) bzw. im zweiten Stromwandler (12) oder die Windungszahl der Sekundärwicklung des ersten (11) oder des zweiten Stromwandlers (12) veränderbar ist.

## Claims

1. Device for detecting an earth fault in the rotor winding (1) of an electric machine, including a first relay (10) in which arrangement the rotor winding is connected via current rails (2, 3) between the poles of an exciter source (4) and to earth (6) via an earth line (5) containing a capacitor (8) and an alternating-voltage source (7) in series, characterized in that the first relay (10) is arranged in the secondary circuit (9.1) of a current transformer (9) the primary side of which is connected into the current rails (2, 3) and into the earth line (5) with the appropriate sense of winding and direction in each case (Fig. 1).

2. Device for detecting an earth fault in the rotor winding (1) of an electric machine, including a first relay (10), in which arrangement the rotor winding is connected via current rails (2, 3) between the poles of an exciter source (4) and to earth (6) via an earth line (5) containing a capacitor (8) and an alternating-voltage source (7), characterized in that the first relay (10) is connected into the secondary circuits (11.1, 12.1), which are preferably connected in parallel, of a first (11) and of a second (12) current transformer, the primary side of the first current transformer (11) being connected into the current rails (2, 3) and the primary side of the second current transformer (12) being connected into the earth line (5) with the appropriate sense of winding and direction in each case (Fig. 2).

3. Device according to one of Claims 1 or 2, characterized in that the first relay (10) is preceded by a first low-pass filter (13).

4. Device according to one of Claims 1 to 3, characterized in that the current transformer (9) or the first (11) and/or the second current transformer (12) are constructed as rail current transformers, particularly as ring core transformers.

5. Device according to one of Claims 2 to 4, characterized in that the first (11) and the second current transformer (12) have at least approximately identically constructed transformer cores and secondary windings.

6. Device according to one of Claims i to 5, characterized in that a second relay (14) is provided which is connected in parallel with an earth resistor (15) which is arranged in the earth line (5).

7. Device according to Claim 6, characterized in that the secondary relay (14) is preceded by a second low-pass filter (16).

8. Device according to one of Claims 1 to 7, characterized in that the sense of winding or direction of the earth line (5) in the current transformer (9) or in the second current transformer (12) or the sense of winding of the secondary winding of the first (11) or of the second current transformer (12) can be reversed by means of a dual change-over switch (17).

9. Device according to one of Claims 1 to 7, characterized in that the number of turns of the earth line (5) in the current transformer (9) or in the second current transformer (12) or the number of turns of the secondary winding of the first (11) or of the second current transformer (12) can be changed by means of a simple change-over switch (17).

## Revendications

1.- Dispositif pour détecter un défaut à la terre dans l'enroulement de rotor (1) d'une machine électrique, comportant un premier relais (10), l'enroulement de rotor étant connecté entre les pôles d'une source d'excitation (4) par l'intermédiaire de barres omnibus (2, 3) et à la terre (6) par l'intermédiaire d'une ligne de terre contenant un condensateur (8) et une source de tension alternative (7) en série, caractérisé en ce que le premier relais (10) est installe dans le circuit secondaire (9.1) d'un transformateur de courant (9) qui est connnecté par son primaire dans les barres omnibus (2, 3) et dans la ligne de terre (5) chaque fois avec un sens d'enroulement ou directionnel correspondant (Fig. 1).

2.- Dispositif pour détecter un défaut à la terre dans l'enroulement de rotor (1) d'une machine électrique comportant un premier relais (10), l'enroulement de rotor étant connecté entre les pôles d'une source d'excitation (4) par l'intermédiaire de barres omnibus (2, 3) et à la terre (6) par l'intermédiaire d'une ligne de terre (5) contenant un condensateur (8) et une source de tension alternative (7) en série, caractérisé en ce que le premier relais (10) est connecté dans des circuits secondaires connectés de préférence en parallèle (11.1, 12.1) d'un premier transformateur de courant (11) et d'un second transformateur de courant (12), étant entendu que le premier transformateur de courant (11) est connecté par son primaire dans les barres omnibus (2, 3) et que le second transformateur de courant (12) est connecté par son primaire dans la ligne de terre (5) chaque fois avec un sens d'enroulement ou directionnel correspondant (Fig. 2).

3.- Dispositif suivant la revendication 1 ou 2, caractérisé en ce qu'un premier filtre passe-bas (13) précède le premier relais (10).

4.- Dispositif suivant l'une quelconque des revendications 1 à 3, caractérisé en ce que le transformateur de courant (9) ou le premier transformateur de courant (11) et/ou le second transformateur de courant (12) ont la forme de transformateurs de courant a barres, en particulier de transformateurs de courant toroïdaux.

5.- Dispositif suivant l'une quelconque des revendications 2 à 4, caractérisé en ce que le premier transformateur de courant (11) et le second transformateur de courant (12) comportent des noyaux de transformateur et des enroulements secondaires au moins à peu près identiques.

6.- Dispositif suivant l'une quelconque des revendications 1 à 5, caractérisé en ce qu'un second relais (14) est prévu et est connecté en parallèle à une résistance de terre (15) installée dans la ligne de terre (5).

7.- Dispositif suivant la revendication 6, caractérisé en ce qu'un second filtre passe-bas (16) précède le second relais (14).

8.- Dispositif suivant l'une quelconque des revendications 1 à 7, caractérisà en ce qu'à l'aide d'un double commutateur inverseur (17), le sens d'enroulement ou directionnel de la ligne de terre (5) dans le transformateur de courant (9) ou dans le second transformateur de courant (12) ou le sens d'enroulement du secondaire du premier transformateur de courant (11) ou du second transformateur de courant (12) peut être inversé.

9.- Dispositif suivant l'une quelconque des revendications 1 à 7, caractérisé en ce qu'au moyen d'un simple commutateur inverseur (17), le nombre de spires de la ligne de terre (5) dans le transformateur de courant (9) ou dans le second transformateur de courant (12) ou le nombre de spires du secondaire du premier transformateur de courant (11) ou du second transformateur de courant (12) peut être modifié.

Fig. 1

Fig. 2

Fig. 3

Fig. 4